# EUROPEAN PATENT SPECIFICATION

(11) **EP 2 406 860 B1**
(45) Date of publication and mention of the grant of the patent: **01.01.2020**
(21) Application number: 10710409.3
(22) Date of filing: 12.03.2010
(51) Int. Cl.: H01S 5/022, H01S 5/065, H01S 5/028, H01S 5/14

(54) **HYBRID INTEGRATED TUNABLE LASER**
HYBRIDER INTEGRIERTER ABSTIMMBARER LASER
LASER ACCORDABLE INTÉGRÉ HYBRIDE

(30) Priority: 12.03.2009 GB 0904247
(43) Date of publication of application: 18.01.2012
(73) Proprietor: Huawei Technologies Co., Ltd., Longgang District Shenzhen, Guangdong 518129 (CN)
(72) Inventor: POUSTIE, Alistair, James, Ipswich Suffolk IP4 5LL (GB); MAXWELL, Graeme, Douglas, Ipswich Suffolk IP4 4LH (GB); SMITH, David, William, Woodbridge IP13 0PG (GB); WYATT, Richard, Woodbridge IP12 1HZ (GB)
(74) Representative: Körber, Martin Hans
(86) International application number: PCT/GB2010/050436
(87) International publication number: WO 2010/103330

(56) References cited:
- EP-A1- 0 552 394
- WO-A1-00/24095
- WO-A1-01/08277
- US-A- 5 113 404
- US-A1- 2006 274 798
- US-A1- 2007 127 539
- US-B1- 6 295 306
- US-B1- 6 556 599
- US-B1- 6 879 619

## Description

The present invention relates to a wavelength tuneable laser.

### BACKGROUND

External cavity tuneable lasers (ECLs) can be constructed from an active gain element, an optical coupling mechanism, a wavelength selective optical element and an optical feedback element, see for example US 5,331,651. Many tuneable ECLs use an optical diffraction grating as the combined wavelength selective and feedback element and the mechanical position of this grating is used to control the lasing wavelength. Three-axis control of the grating is usually required to maintain the laser wavelength and the optimum lasing feedback condition. It is also known that incorporating a thin film filter in the external cavity can allow a selection of a number of longitudinal laser modes in the laser cavity, see for example P. Zorabedian and W. R. Trutna, Jr., "Interference-filter-tuned, alignment-stabilized, semiconductor external-cavity laser," Opt. Lett. 13, p.826 (1988). US6556599 discloses a tuneable laser cavity.

The document US 2006/0274798 A1 shows an electronic wavelength marker system and method. Especially, the system produces wavelength tunable laser light and comprises a laser cavity including an optical gain medium and a wavelength selective element disposed in a path of light emitted by the optical gain medium, such that changing a position of the element changes a wavelength emitted by the medium.

The document US 6 556 599 B1 shows an external cavity laser using an angle-tuned filter and an according method.

The document WO 01/08277 A1 shows an apparatus and method for filtering an optical beam.

The document US 2007/0127539 A1 shows a narrow band laser with wavelength stability. Especially, the use of a rotatable filter for adjusting the wavelength of the laser is shown.

The document US 5,113,404 shows an optical arrangement on a silicon base. Especially, the document shows etching holes into the surface of the silicon base and mounting optical components using these holes.

### BRIEF SUMMARY OF THE DISCLOSURE

In accordance with the present invention there is provided a wavelength tuneable, single longitudinal mode external cavity laser device according to claim 1.

Thus, the invention provides a wavelength tuneable laser that operates on a single longitudinal mode and the single-mode wavelength is determined by single axis angle tuning of a narrowband thin-film coated filter in the cavity. In embodiments of the invention only a single thin-film coated filter may be interposed in the optical path between the gain medium and the reflective element.

The adjustment mechanism is configured to maintain the angular position of the filter to the optical path in the absence of electrical power to the motor. Thus, according to embodiments of the invention, the mechanical tuning of the filter is achieved with a compact piezo micromotor that does not require any electrical power to be applied to maintain the lasing wavelength. Such piezo micromotors are readily available, for example for use in the focussing mechanisms of digital cameras.

The thin-film filter may be provided on a filter substrate that is thermally matched to the narrowband thin-film coating. The thin-film filter may be provided on a plane parallel filter substrate.

Thermal compensation of the thin-film coated filter with the substrate material also allows the laser to maintain wavelength with varying temperatures. These features allow the laser to return to the previously set wavelength after all electrical power is removed then reapplied which is a feature that has not been possible with previous tuneable laser designs.

One or more of the gain medium, the collimating lens, the reflective element and the filter may be located mechanically on the substrate material by locating formations defined lithographically on the substrate material. Complementary locating formations may be formed on the gain medium, the reflective element and/or the filter. Thus, in embodiments of the invention, the optical pieceparts of the laser are aligned by passive alignment techniques to greatly reduce the packaging cost of the tuneable laser.

The optical mode field within the semiconductor optical amplifier gain medium may be expanded before exiting an output facet of the amplifier.

Thus, there is disclosed herein a wavelength tuneable external cavity laser featuring a semiconductor optical amplifier gain medium where single longitudinal mode operation and wavelength are determined by a single thin-film coated filter. The wavelength tuning may be achieved by mechanically angle-tuning the thin-film coated filter. The laser device further comprises a mechanism to adjust mechanically the angle of the thin film filter to said optical path. The mechanism comprises a single-axis piezo micro-motor arranged to adjust the angle of the thin-film filter to said optical path. One or more of the gain medium, the reflective element and the filter, are located mechanically on the substrate material by locating formations defined lithographically on the substrate material.

The nominal operating wavelength remains set even after electrical power is removed from the mechanism used to adjust the angle of thin film filter. The thin-film coated filter may be on a thermally matched substrate to reduce the variation in laser wavelength with temperature. The thin-film coated filter may be on a plane parallel thermally matched substrate to maintain laser cavity alignment with angle. Variations in the normal incidence wavelength of the grown thin-film coated filter may be compensated by varying the angle of incidence of the filter. Adjustment of the laser wavelength over a restricted wavelength range is possible by small adjustments of the current into the semiconductor optical amplifier gain medium. The mode field within the semiconductor optical amplifier is expanded before exiting the amplifier output facet.

### BRIEF DESCRIPTION OF THE DRAWINGS

Embodiments of the invention are further described hereinafter with reference to the accompanying drawings, in which:
Figure 1 is a schematic representation showing the component parts of an external cavity tuneable laser according to an embodiment of the invention;
Figure 2 is a chart of a calculation showing how the central wavelength of the thin-film optical filter varies with angle of incidence; and

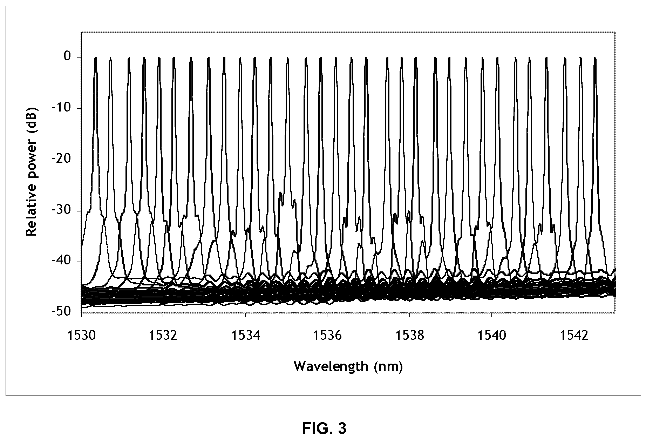

Figure 3 is a chart showing the measured composite spectrum for a laser tuned to different wavelengths via filter angle.

### DETAILED DESCRIPTION

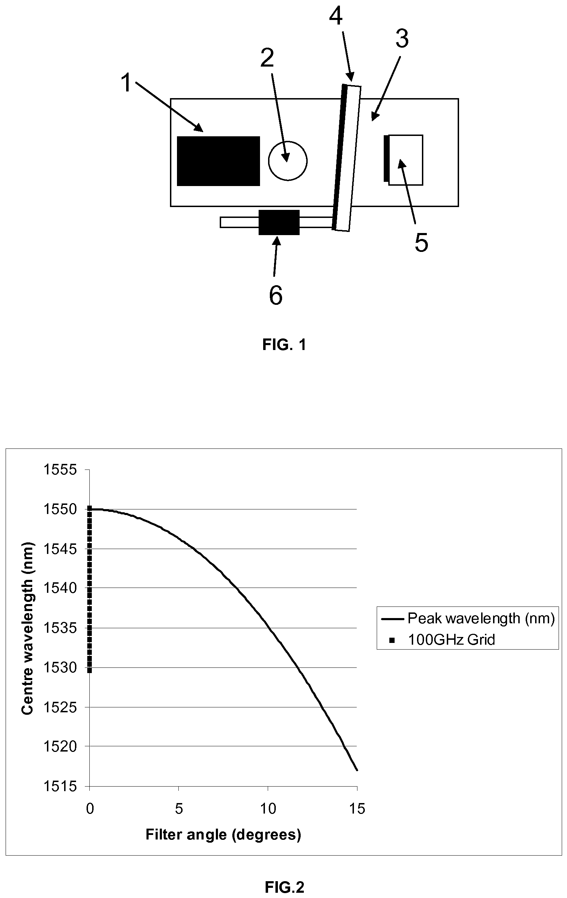

According to an embodiment of the invention, as shown in Figure 1, a laser cavity is formed between one facet of a broadband semiconductor gain element 1 and a reflective element 5. The value of reflectivity of the semiconductor gain element facet is controlled by the deposition of thin-film coatings onto the chip facet. The reflectivity of the other facet of the semiconductor gain element 1 is minimised by using optical mode expansion, an angled waveguide to the facet and thin-film coatings. The gain element 1 has precision etched features to allow the chip to be passively aligned to a silicon carrier 3. The reflective element 5 at the other end of the cavity can incorporate thin-film coatings to control the reflectivity value. This reflectivity can also be wavelength selective if required. The reflective element 5 is aligned via precision mechanical stops on the silicon carrier 3.

In addition to the semiconductor gain element 1, the laser cavity contains a lens 2 to collimate the output light from the gain element 1 into the external cavity. The lens 2 can be a precision sized ball lens with anti-reflection coatings, suitable for passive assembly with the silicon etched carrier 3. The collimated light passes through a thin-film coated filter element 4 that is a narrow passband filter (FWHM∼50GHz) deposited on a thermally matched substrate (optical glass F7). The bandwidth of the filter 4 is sufficiently narrow, typically less than 0.5nm (FWHM, single pass) that only a few longitudinal modes of the laser lie within the filter passband and hence single-mode operation of the laser is favoured.

The centre wavelength of the filter 4 varies with angle of incidence as shown in Figure 2 and the filter angle is used to tune the laser wavelength. The angle of the filter element is controlled mechanically via a compact, single axis piezo-micromotor 6 that has the feature of positional stability when the power is removed from the micromotor 6. Thus, once the filter angle has been set to determine the laser wavelength, the power can be removed from the micromotor 6 and the laser will remain at the determined wavelength. This aspect greatly reduces the overall electrical power requirement for the laser. The filter substrate is plane parallel with an antireflection coating on the opposite side from the filter. This allows simplified alignment of the filter element in the laser cavity by maintaining the angular alignment of the beam in the external cavity. In addition, any small variations in the normal incidence wavelength of the manufactured thin-film filter element can be compensated for by tuning each individual laser filter to different angles. This reduction in manufacturing accuracy for the thin-film filter wavelength greatly increases the yield and hence reduces the cost of the overall laser assembly.

For some applications which require the laser wavelength to be adjusted by small amounts to allow the laser to be either locked precisely to an external reference source or track other wavelength sensitive components in a system an additional method of fine tuning can be included in the embodiment. This fine tuning can typically achieved by making small changes of bias current to the active gain block 1. For an indium phosphide (InP) based reflective semiconductor optical amplifier of 2.7mm length a bias current adjustment of 1mA can change the laser frequency by the order of 100MHz.

Thus, in general terms, there is disclosed herein a hybrid integrated tuneable optical laser device, and in particular one suitable for tuning to different wavelengths via a piezo micromotor controlled optical filter in an external cavity. Once the laser is fixed at a selected wavelength, no power is required to be applied to the wavelength tuning element to maintain the wavelength stability. Applications are expected in telecommunications and sensors.

The invention, at least in the preferred embodiment goes beyond the prior art by using a piezo-micromotor to control the laser wavelength via a single optical filter, to thermally stabilise the lasing wavelength and to achieve low power operation once the wavelength is set.

## Claims

1. A wavelength tuneable, single longitudinal mode external cavity laser device comprising a semiconductor optical amplifier gain medium (1), a collimating lens (2), and a reflective element (5) arranged relative to the gain medium to form a laser cavity,
wherein the device further comprises a single narrowband thin-film coated filter (4) interposed in the optical path between the gain medium and the reflective element, whereby the laser wavelength is tuneable by adjusting the angle of the thin-film filter to said optical path,
wherein the laser device further comprises a mechanism to adjust mechanically the angle of the thin film filter (4) to said optical path, the mechanism comprising a single-axis piezo micro-motor (6) arranged to adjust the angle of the thin-film filter to said optical path,
wherein the wavelength tuneable, single longitudinal mode external cavity laser device further comprises a substrate material (3),
wherein one or more of the gain medium (1), the reflective element (5) and the filter, are located mechanically on the substrate material (3) by locating formations defined lithographically on the substrate material, and
wherein the adjustment mechanism is configured to maintain the angular position of the filter (4) to the optical path in the absence of electrical power to the motor (6).

2. A laser device as claimed in claim 1, wherein the narrowband thin-film filter (4) is provided on a filter substrate that is thermally matched to the thin-film filter coating.

3. A laser device as claimed in claim 2, wherein the thin-film filter (4) is provided on a plane parallel filter substrate.

4. A laser device as claimed in any preceding claim, wherein the thin film filter passband is less than 0.5nm FWHM.

5. A laser device as claimed in any preceding claim, wherein the mode field within the semiconductor optical amplifier gain medium (1) is expanded before exiting an output facet of the amplifier.

## Patentansprüche

1. Wellenlängenabstimmbare Einzel-Longitudinalmodus-Laservorrichtung mit externem Resonator, die ein optisches Halbleiterverstärker-Verstärkungsmedium (1), eine Kollimationslinse (2) und ein reflektierendes Element (5), relativ zu dem Verstärkungsmedium zur Bildung eines Laserresonators angeordnet, umfasst,
wobei die Vorrichtung ferner ein einziges schmalbandiges beschichtetes Dünnfilmfilter (4) umfasst, das in dem optischen Pfad zwischen dem Verstärkungsmedium und dem reflektierenden Element angeordnet ist,
wobei die Laserwellenlänge durch Justieren des Winkels des Dünnfilmfilters auf den optischen Pfad abstimmbar ist,
wobei die Laservorrichtung ferner einen Mechanismus zum mechanischen Justieren des Winkels des Dünnfilmfilters (4) auf den optischen Pfad umfasst, wobei der Mechanismus einen Einzelachsen-Piezomikromotor (6) umfasst, der dafür ausgelegt ist, den Winkel des Dünnfilmfilters auf den optischen Pfad zu justieren,
wobei die wellenlängenabstimmbare Einzel-Longitudinalmodus-Laservorrichtung mit externem Resonator ferner ein Substratmaterial (3) umfasst,
wobei eines oder mehrere des Verstärkungsmediums (1), des reflektierenden Elements (5) und des Filters durch lithografisch auf dem Substratmaterial definierte Lokalisierungsformationen mechanisch auf dem Substratmaterial (3) lokalisiert sind, und
wobei der Justierungsmechanismus dafür ausgelegt ist, die Winkelposition des Filters (4) bei Abwesenheit elektrischer Stromversorgung des Motors (6) auf dem optischen Pfad zu halten.

2. Laservorrichtung nach Anspruch 1,
wobei das schmalbandige Dünnfilmfilter (4) auf einem Filtersubstrat vorgesehen ist, das thermisch an die Dünnfilmfilterbeschichtung angepasst ist.

3. Laservorrichtung nach Anspruch 2, wobei das Dünnfilmfilter (4) auf einem planparallelen Filtersubstrat vorgesehen ist.

4. Laservorrichtung nach einem der vorhergehenden Ansprüche,
wobei das Dünnfilmfilter-Durchlassband kleiner als 0,5 nm FWHM ist.

5. Laservorrichtung nach einem der vorhergehenden Ansprüche,
wobei das Modusfeld in dem optischen Halbleiterverstärker-Verstärkungsmedium (1) vor dem Austritt aus einer Ausgangsfacette des Verstärkers expandiert wird.

## Revendications

1. Dispositif laser à cavité externe à mode longitudinal unique, réglable en longueur d'onde, comprenant un milieu de gain d'amplificateur optique à semi-conducteur (1), une lentille de collimation (2), et un élément réfléchissant (5) agencé par rapport au milieu de gain pour former une cavité laser,
le dispositif comprenant en outre un filtre revêtu d'une couche mince à bande étroite unique (4) interposé dans le trajet optique entre le milieu de gain et l'élément réfléchissant, la longueur d'onde du laser pouvant être réglée en ajustant l'angle du filtre à couche mince audit trajet optique,
le dispositif laser comprenant en outre un mécanisme pour ajuster mécaniquement l'angle du filtre à couche mince (4) audit trajet optique, le mécanisme comprenant un micromoteur piézoélectrique à axe unique (6) agencé pour ajuster l'angle du filtre à couche mince audit trajet optique,
le dispositif laser à cavité externe à mode longitudinal unique, réglable en longueur d'onde, comprenant en outre un matériau de substrat (3),
un ou plusieurs parmi le milieu de gain (1), l'élément réfléchissant (5) et le filtre étant situés mécaniquement sur le matériau de substrat (3) en localisant des formations définies lithographiquement sur le matériau de substrat, et le mécanisme de réglage étant configuré pour maintenir la position angulaire du filtre (4) sur le trajet optique en l'absence d'alimentation électrique au moteur (6).

2. Dispositif laser selon la revendication 1, le filtre à couche mince à bande étroite (4) étant prévu sur un substrat de filtre qui est thermiquement adapté au revêtement du filtre à couche mince.

3. Dispositif laser selon la revendication 2, le filtre à couche mince (4) étant prévu sur un substrat de filtre plan parallèle.

4. Dispositif laser selon n'importe quelle revendication précédente, la bande passante du filtre à couche mince étant inférieure à 0,5 nm FWHM (largeur à mi-hauteur).

5. Dispositif laser selon n'importe quelle revendication précédente, le champ de mode à l'intérieur du milieu de gain d'amplificateur optique à semi-conducteur (1) étant étendu avant de sortir d'une facette de sortie de l'amplificateur.
